Europäisches Patentamt

European Patent Office

Office européen des brevets

(19)

(11) Publication number : **0 579 279 B1**

(12) **EUROPEAN PATENT SPECIFICATION**

(45) Date of publication of patent specification :
06.12.95 Bulletin 95/49

(51) Int. Cl.[6] : **H01L 39/24**

(21) Application number : **93115248.2**

(22) Date of filing : **11.08.89**

(54) Single-crystal wafer having a superconductive ceramic thin film formed thereon.

(43) Date of publication of application :
19.01.94 Bulletin 94/03

(60) Publication number of the earlier application in accordance with Art. 76 EPC : **0 412 199**

(45) Publication of the grant of the patent :
06.12.95 Bulletin 95/49

(84) Designated Contracting States :
**DE FR GB**

(56) References cited :
**EP-A- 0 301 656**

(73) Proprietor : **Mitsubishi Materials Corporation
No. 5-2, Ohtemachi, 1-chome
Chiyoda-ku
Tokyo 100 (JP)**

(72) Inventor : **Sugihara, Tadashi, c/o Chuo
Kenkyusho, Mitsubishi
Materials Corp.,
No. 297 Kitabukuro-cho 1-chome
Ohmiya-shi, Saitama-ken (JP)**
Inventor : **Takeshita, Takuo, c/o Chuo
Kenkyusho, Mitsubishi
Materials Corp.,
No. 297 Kitabukuro-cho 1-chome
Ohmiya-shi, Saitama-ken (JP)**

(74) Representative : **May, Hans Ulrich, Dr.
Patentanwalt Dr.H.U.May,
Thierschstrasse 27
D-80538 München (DE)**

**Description**

BACKGROUND OF THE INVENTION

This invention relates to a single-crystal wafer having a superconductive ceramic thin film formed thereon for semiconductor devices, such as LSI's and Josephson devices.

Conventionally, attempts have been made to use as a material for semiconductor devices, such as LSI's and Josephson devices, a single-crystal wafer having a superconductive ceramic thin film formed thereon (hereinafter referred to as "a superconductive thin film-formed wafer"), which is prepared by forming a superconductive ceramic thin film (hereinafter referred to as "a superconductive thin film") containing as a main phase a crystalline phase having a composition by atomic ratio selected from the group consisting of $Bi_2Sr_2Ca_1Cu_2O_8$ and $Bi_2Sr_2Ca_2Cu_3O_{10}$ on a surface of a single-crystal wafer formed of Si, Ga-As, or the like by sputtering or PVD (physical vapor deposition) by the use of a target having a composition by atomic ratio selected from the group consisting of $Bi_2Sr_2Ca_1Cu_3O_{10}$ and $Bi_2Sr_2Ca_2Cu_4O_{12}$, and then subjecting the resulting wafer to heat treatment under an oxygen atmosphere at a temperature of 890 °C ± 2 °C over 20 to 50 hours for crystalline orientation of the thin film.

Also, attempts have been made to use as a material for semiconductor devices, such as LSI's and Josephson devices, a superconductive thin film-formed wafer, which is prepared by forming a superconductive thin film containing as a main phase a crystalline phase having a composition by atomic ratio selected from the group consisting of $Tl_2Ba_2Ca_1Cu_2O_8$, $Tl_2Ba_2Ca_2Cu_3O_{10}$, $Tl_1Ba_2Ca_1Cu_2O_7$, $Tl_1Ba_2Ca_2Cu_3O_9$, and $Tl_1Ba_2Ca_3Cu_4O_{11}$ on a surface of a single-crystal wafer formed of Si, Ga-As, or the like by sputtering or PVD (physical vapor deposition) by the use of a target having a composition by atomic ratio selected from the group consisting of $Tl_2Ba_2Ca_1Cu_3O_{10}$, $Tl_2Ba_2Ca_2Cu_4O_{12}$, $Tl_1Ba_2Ca_1Cu_3O_8$, $Tl_1Ba_2Ca_2Cu_4O_{10}$, and $Tl_1Ba_2Ca_3Cu_5O_{12}$, and then subjecting the resulting wafer to heat treatment in an infrared oven under an atmosphere containing Tl vapor at a temperature of 900 °C ± 2 °C over 10 to 30 minutes, followed by quenching, for crystalline orientation of the thin film.

It is also known, for example from EP-A-0 301 525, and a paper entitled "Formation of Y-Ba-Cu-O Superconducting Thin Films on Semiconductor Substrates" (Extended Abstracts of the 20th (1988 International) Conference on Solid State Devices and Materials, Tokyo, 1988, pp. 427-430), to form a superconductive thin film with a high critical temperature of good quality by forming a crystalline coating film such as a $CaF_2$ film, on a surface of a single-crystal wafer substrate formed of silicon or GaAs, followed by forming thereon a Y-Ba-Cu-O based superconductive thin film by means of a thin film technique, such as sputtering.

In the meanwhile, there is an increasing demand for a superconductive thin film to be formed on a single-crystal wafer, which has a still higher critical temperature (Tc) at which the film shows superconductivity, in order to cope with recent higher performance and increased wiring density of semiconductor devices.

SUMMARY OF THE INVENTION

It is the object of the invention to provide a superconductive thin film-formed wafer which has a superconductive thin film with a higher critical temperature (Tc).

To attain the above object, the present invention provides a superconductive ceramic thin film-formed single-crystal wafer comprising:

a single-crystal wafer;

an intermediate ceramic thin film formed on a surface of the single-crystal wafer; and

a superconductive ceramic thin film formed on the intermediate ceramic thin film,

the intermediate ceramic thin film comprising as a main phase, a crystalline phase having a composition by atomic ratio selected from the group consisting of

$Tl_1Ba_2Ca_sO_t$ (provided that s: 1 to 2; and t: 4.5 to 5.5) and

$Tl_2Ba_2Ca_vO_w$ (provided that v: 1 to 3; and w: 6 to 8),

and the superconductive ceramic thin film comprising as a main phase, a crystalline phase having a composition by atomic ratio selected from the group consisting of

$Tl_2Ba_2Ca_1Cu_2O_8$,

$Tl_2Ba_2Ca_2Cu_3O_{10}$,

$Tl_1Ba_2Ca_1Cu_2O_7$,

$Tl_1Ba_2Ca_2Cu_3O_9$, and

$Tl_1Ba_2Ca_3Cu_4O_{11}$.

Also preferably, the single-crystal wafer comprises Si.

Alternatively, the single-crystal wafer comprises Ga-As.

Preferably, the intermediate ceramic thin film has a thickness within a range of 50 to 200 nm (500 to 2000 Å)

DETAILED DESCRIPTION

Under the aforestated circumstances, we have made studies to develop a superconductive thin film for single-crystal wafers, which has a higher critical temperature, and reached the following findings:

If a ceramic thin film containing as a main phase a crystalline phase having a composition by atomic ratio selected from the group consisting of $Tl_1Ba_2Ca_sO_t$ (provided that s: 1 to 2; and t: 4.5 to 5.5) and $Tl_2Ba_2Ca_vO_w$ (provided that v: 1 to 3; and w: 6 to 8), preferably having a thickness of 50 to 200 nm (500 to 2000 Å), is formed as an intermediate layer on a surface of a single-crystal wafer formed of Si, Ga-As, before forming the second-mentioned superconductive thin film thereon, the superconductive thin film of the superconductive thin film-formed wafer after being subjected to heat treament for crystalline orientation of the thin film also has a still higher critical temperature.

The present invention is based upon the above findings, and provides a supercondutive thin film-formed wafer having the aforestated structure.

The compositions of the crystalline phases which each form the main phase of the intermediate thin film of the superconductive thin film-formed wafer according to the invention have been experimentally determined. As clearly shown by comparative examples in Table 1 set forth hereinafter, if the main phase is a crystalline phase having a composition outside the above-described range, the wafer does not exhibit a desirably high critical temperature.

Further, the thickness of the intermediate thin film of the superconductive thin film-formed wafer according to the invention is preferably 50 to 200 nm (500 to 2000 Å), because if the thickness is smaller than 50 nm (500 Å), the critical temperature cannot be increased to a desired level, whereas if the thickness is greater than 200 nm (2000 Å) the critical temperature can be increased to a desired level, but no greater effect can be obtained by increasing the thickness above 200 nm (2000 Å). Therefore it is not economical to form the thin film having a greater thickness.

Examples of the superconductive thin film-formed wafer according to the invention will be described in detail below.

Example 1

As a substrate, a single-crystal wafer of Si having a diameter of 50.0 mm and a thickness of 0.35 mm was prepared. The substrate was mounted on a conventional sputtering apparatus. Sputtering was carried out by the use of a target for formation of an intermediate thin film, which has a composition shown in Table 1, a diameter of 127 mm and a thickness of 6 mm, under the following conditions:

Radio Frequency Power (13.56 MHz): 200 W
Degree of Vacuum: 2,66 Pa (20mTorr)
Atmosphere: $O_2/(Ar + O_2) = 1/5$ (v/v)
Distance between Substrate and Target: 70 mm
Substrate Temperature: 680 °C

Thus, an intermediate thin film having substantially the same composition as the target and an average thickness shown in Table 2 was formed on a surface of the substrate. The resulting wafer was subjected to heat treatment for crystallization by holding same in an infrared oven under a Tl atmosphere at a temperature of 700 °C over 10 minutes, followed by quenching. Then, sputtering was carried out by the use of a target for formation of a superconductive thin film, which has a composition shown in Table 2, a diameter of 127 mm and a thickness of 6 mm, under the following conditions:

Radio Frequency Power (13.56 MHz): 200 W
Degree of Vacuum: 1,33 Pa (10mTorr)
Atmosphere: $O_2/(Ar + O_2) = 1/10$ (v/v)
Distance between Substrate and Target: 70 mm
Substrate Temperature: 720 °C

| SPECIMEN | | COMPOSITION OF TARGET FOR INTERMEDIATE THIN FILM (ATOMIC RATIO) | AVERAGE THICKNESS OF INTERMEDIATE THIN FILM 0.1nm (Å) | COMPOSITION OF TARGET FOR SUPERCONDUCTIVE THIN FILM (ATOMIC RATIO) | SUPERCONDUCTIVE THIN FILM | | | |
|---|---|---|---|---|---|---|---|---|
| | | | | | COMPOSITION OF MAIN CRYSTALLINE PHASE (ATOMIC RATIO) | CONTENT OF MAIN CRYSTALLINE PHASE (% BY VOLUME) | AVERAGE THICKNESS (μm) | CRITICAL TEMPERATURE (Tc) |
| SUPERCONDUCTIVE THIN FILM-FORMED WAFERS ACCORDING TO PRESENT INVENTION | 7 | $Tl_1Ba_2Ca_1O_{4.5}$ | 500 | $Tl_1Ba_2Ca_1Cu_3O_8$ | $Tl_1Ba_2Ca_1Cu_2O_7$ | 97 | 1.5 | 72 |
| | 8 | $Tl_1Ba_2Ca_{1.5}O_{5.0}$ | 1000 | $Tl_2Ba_2Ca_2Cu_4O_{12}$ | $Tl_2Ba_2Ca_2Cu_3O_{10}$ | 93 | 1.0 | 118 |
| | 9 | $Tl_1Ba_2Ca_2O_{5.5}$ | 2000 | $Tl_2Ba_2Ca_1Cu_3O_{10}$ | $Tl_2Ba_2Ca_1Cu_2O_8$ | 95 | 1.3 | 103 |
| | 10 | $Tl_2Ba_2Ca_1O_6$ | 1000 | $Tl_1Ba_2Ca_2Cu_4O_{10}$ | $Tl_1Ba_2Ca_2Cu_3O_9$ | 89 | 0.9 | 110 |
| | 11 | $Tl_2Ba_2Ca_2O_7$ | 500 | $Tl_1Ba_2Ca_1Cu_3O_8$ | $Tl_1Ba_2Ca_1Cu_2O_7$ | 91 | 1.0 | 73 |
| | 12 | $Tl_2Ba_2Ca_3O_8$ | 500 | $Tl_1Ba_2Ca_3Cu_5O_{12}$ | $Tl_1Ba_2Ca_3Cu_4O_{11}$ | 94 | 1.1 | 115 |
| COMPARATIVE SUPERCONDUCTIVE THIN FILM-FORMED WAFERS | 4 | -- | 500 | $Tl_2Ba_2Ca_1Cu_3O_{10}$ | $Tl_2Ba_2Ca_1Cu_2O_8$ | 93 | 1.3 | 30 |
| | 5 | $Tl_1Ba_2O_{3.5}$ | 500 | $Tl_1Ba_2Ca_1Cu_3O_8$ | $Tl_1Ba_2Ca_1Cu_2O_7$ | 90 | 1.5 | 36 |
| | 6 | $Tl_1Ba_2Ca_{2.5}O_6$ | 1000 | $Tl_2Ba_2Ca_1Cu_3O_{10}$ | $Tl_2Ba_2Ca_1Cu_2O_8$ | 92 | 1.0 | 45 |
| | 7 | $Tl_2Ba_2Ca_{0.5}O_{5.5}$ | 2000 | $Tl_1Ba_2Ca_2Cu_4O_{10}$ | $Tl_1Ba_2Ca_2Cu_3O_9$ | 96 | 1.0 | 36 |
| | 8 | $Tl_2Ba_2Ca_{3.5}O_{7.5}$ | 500 | $Tl_1Ba_2Ca_3Cu_5O_{12}$ | $Tl_1Ba_2Ca_3Cu_4O_{11}$ | 93 | 1.5 | 40 |

T a b l e  1

Thus, a superconductive thin film in which the main crystalline phase has a composition, a content, and an average thickness shown in Table 1 was formed on the intermediate thin film. The resulting wafer was further subjected to heat treatment for crystalline orientation by holding same in an infrared oven under a Tl atmosphere at a temperature of 900 °C over 30 minutes, followed by quenching, to obtain a superconductive thin film-formed wafer. In this manner, there were prepared superconductive thin film-formed wafers Nos. 7 to 12 according to the invention and comparative superconductive thin film-formed wafers Nos. 4 to 8.

The comparative superconductive thin film-formed wafers Nos. 4 to 8 each contain an intermediate thin film having a composition outside the scope of the present invention.

Then, the critical temperature (Tc) of the superconductive thin films of the superconductive thin film-formed wafers Nos. 7 to 12 of the present invention and the comparative superconductive thin film-formed wafers Nos. 4 to 8 was measured. The results are shown in Table 1.

From the results, it is clear that by virtue of the presence of the intermediate thin film, the superconductive thin films of the superconductive thin film-formed wafers Nos. 7 to 12 according to the invention have higher critical temperatures than the comparative wafer No. 4 which has no intermediate thin film, and the comparative wafers Nos. 5 to 8 which each have an intermediate thin film having a composition outside the scope of the present invention.

As described above, the wafer according to the invention has a superconductive thin film showing a markedly high critical temperature. Therefore, semiconductor devices prepared therefrom can fully satisfy the demand for higher performance and increased wiring density of semiconductor devices.

## Claims

1. A superconductive ceramic thin film-formed single-crystal wafer comprising:

    a single-crystal wafer;

    an intermediate ceramic thin film formed on a surface of said single-crystal wafer; and

    a superconductive ceramic thin film formed on said intermediate ceramic thin film,

**characterized in that** said

intermediate ceramic thin film comprises, as a main phase, a crystalline phase having a composition by atomic ratio selected from the group consisting of

    $Tl_1Ba_2Ca_sO_t$ (provided that s: 1 to 2; and t: 4.5 to 5.5) and

    $Tl_2Ba_2Ca_vO_w$ (provided that v: 1 to 3; and w: 6 to 8),

and said superconductive ceramic thin film comprises as a main phase, a crystalline phase having a composition by atomic ratio selected from the group consisting of

    $Tl_2Ba_2Ca_1Cu_2O_8$,

    $Tl_2Ba_2Ca_2Cu_3O_{10}$,

    $Tl_1Ba_2Ca_1Cu_2O_7$,

    $Tl_1Ba_2Ca_2Cu_3O_9$, and

    $Tl_1Ba_2Ca_3Cu_4O_{11}$.

2. A wafer as claimed in claim 1, wherein said single-crystal wafer comprises Si.

3. A wafer as claimed in claim 1, wherein said single-crystal wafer comprises Ga-As.

4. A wafer as claimed in claim 1, wherein said intermediate ceramic thin film has a thickness within a range of 50 to 200 nm (500 to 2000 Å).

## Patentansprüche

1. Einkristall-Wafer mit einer darauf abgeschiedenen supra-leitenden keramischen Dünnschicht, welche aufweist:

    - eine Einkristall-Wafer;

    - eine keramische Dünnschicht-Zwischenschicht, die auf einer Oberfläche der Einkristall-Wafer gebildet ist und

    - eine supra-leitende keramische Dünnschicht, die auf der keramischen Dünnschicht-Zwischenschicht gebildet ist,

**dadurch gekennzeichnet,** daß die keramische Dünnschicht-Zwischenschicht als eine Hauptphase eine kristalline Phase mit einer Zusammensetzung nach Atomverhältnis aus der Gruppe von $Tl_1Ba_2Ca_sO_t$, worin s = 1 bis 2 und t = 4,5 bis 5,5, und $Tl_2Ba_2Ca_vO_w$, worin v = 1 bis 3 und w = 6 bis 8, enthält und daß die supra-leitende keramische Dünnschicht als eine Hauptphase eine kristalline Phase enthält, deren Zusammensetzung nach Atomverhältnis ausgewählt ist aus der Gruppe $Tl_2Ba_2Ca_1Cu_2O_8$, $Tl_2Ba_2Ca_2Cu_3O_{10}$, $Tl_1Ba_2Ca_1Cu_2O_7$, $Tl_1Ba_2Ca_2Cu_3O_9$ und $Tl_1Ba_2Ca_3Cu_4O_{11}$.

2. Wafer nach Anspruch 1, worin die Einkristall-Wafer Si enthält.

3. Wafer nach Anspruch 1, worin die Einkristall-Wafer Ga-As enthält.

4. Wafer nach Anspruch 1, worin die keramische Dünnschicht-Zwischenschicht eine Dicke im Bereich von 50 bis 200 nm (500 bis 2000 Å) hat.

## Revendications

1. Tranche monocristalline avec pellicule céramique mince supraconductrice, comprenant :
une tranche monocristalline ;
une pellicule céramique mince intermédiaire formée sur une surface de ladite tranche monocristalline ; et
une pellicule céramique mince supraconductrice formée sur ladite pellicule céramique mince intermédiaire,
caractérisée en ce que ladite pellicule céramique mince intermédiaire comprend, en tant - que phase principale, une phase cristalline ayant une composition en proportion atomique choisie dans le groupe constitué de
$Tl_1Ba_2Ca_sO_t$ (à conditions que s : 1 à 2 ; et que t : 4,5 à 5,5) et
$Tl_2Ba_2Ca_vO_w$ (à condition que v : 1 à 3 ; et que w : 6 à 8),
et en ce que ladite pellicule céramique mince supraconductrice comprend, en tant que phase principale, une phase cristalline ayant une composition en proportion atomique choisie dans le groupe constitué de
$Tl_2Ba_2Ca_1Cu_2O_8$,
$Tl_2Ba_2Ca_2Cu_3O_{10}$,
$Tl_1Ba_2Ca_1Cu_2O_7$,
$Tl_1Ba_2Ca_2Cu_3O_9$, et
$Tl_1Ba_2Ca_3Cu_4O_{11}$.

2. Tranche selon la revendication 1, dans laquelle ladite tranche monocristalline comprend Si.

3. Tranche selon la revendication 1, dans laquelle ladite tranche monocristalline comprend Ga-As.

4. Tranche selon la revendication 1, dans laquelle ladite pellicule céramique mince intermédiaire a une épaisseur dans la gamme de 50 à 200 (500 à 2000 Å).